# EUROPEAN PATENT APPLICATION

(11) **EP 4 650 794 A1**
(43) Date of publication of application: **19.11.2025**
(21) Application number: 25170444.1
(22) Date of filing: 14.04.2025
(51) Int. Cl.: G01R 27/26, G01R 31/00, G01R 31/42, G01R 31/64, G01R 31/40

(54) **SYSTEMS AND METHODS FOR TESTING CAPACITORS IN AN INVERTER**

(30) Priority: 09.05.2024 US 202418659761
(71) Applicant: BorgWarner US Technologies LLC, Wilmington, DE 19801 (US)
(72) Inventor: NAVARRO, Nomel Centino, Singapore (SG); NAIK, Karthik, Singapore (SG)
(74) Representative: Office Freylinger

(57) **Abstract**

Disclosed techniques relate to a system for testing a capacitor. An example system includes an inverter to convert DC power from a battery to AC power to drive a motor. The inverter includes a noise filter including a first capacitor connected in series with a second capacitor and a testing circuit configured to test one or more of the first capacitor or the second capacitor. The testing circuit includes a voltage divider including resistors; a voltage detector configured to measure a voltage at the voltage divider; a switch configured to connect the noise filter to the voltage divider; and one or more controllers configured to control an operation of the switch to connect the noise filter to the voltage divider, and to determine, from an output of the voltage detector, whether one or more of the first capacitor or the second capacitor are connected to the noise filter.

## Description

### TECHNICAL FIELD

Various embodiments of the present disclosure relate generally to testing a capacitor, and more particularly, but without limitation, to systems and methods for testing capacitors used in high voltage circuits such as power inverters for electric vehicles.

### BACKGROUND

Capacitors are widely used in high voltage applications, such as inverters, for example, for different purposes, such as smoothing out ripples in voltages. Circuits that use capacitors may be exposed to environmental factors such as heat, cold, humidity, and impact. Due to these environmental factors, capacitors may detach from a circuit board or fail, which may result in an open circuit in the system, and thereby reducing the performance of the system.

The present disclosure is directed to overcoming these challenges.

### SUMMARY OF THE DISCLOSURE

In some aspects, the techniques described herein relate to a system including: an inverter to convert DC power from a battery to AC power to drive a motor. The inverter includes: a noise filter including a first capacitor connected in series with a second capacitor; and a testing circuit configured to test one or more of the first capacitor or the second capacitor, the testing circuit including: a voltage divider including resistors; a voltage detector configured to measure a voltage at the voltage divider; a switch configured to connect the noise filter to the voltage divider; and one or more controllers configured to (i) control an operation of the switch to connect the noise filter to the voltage divider, and to (ii) determine, from an output of the voltage detector, whether one or more of the first capacitor or the second capacitor are connected to the noise filter.

In some aspects, the techniques described herein relate to a system. The voltage divider and the noise filter are connected to a positive DC voltage source and to a negative DC voltage source.

In some aspects, the techniques described herein relate to a system. The resistors include a first resistor, a second resistor, a third resistor, and a fourth resistor. The first resistor is connected to a positive DC voltage source and the second resistor. The second resistor is connected to the third resistor, and the voltage detector is connected to the third resistor and the fourth resistor.

In some aspects, the techniques described herein relate to a system. The one or more controllers are further configured to: determine that the measured voltage is above a first threshold for a period of time; and responsive to determining that the measured voltage is above the first threshold for the period of time, determine that the first capacitor and the second capacitor are connected to the noise filter.

In some aspects, the techniques described herein relate to a system. The one or more controllers are further configured to: determine that the measured voltage is below a second threshold for a period of time; and responsive to determining that the measured voltage is below the second threshold for a period of time, determine that the first capacitor is disconnected from the noise filter.

In some aspects, the techniques described herein relate to a system. The one or more controllers are further configured to: determine that the measured voltage is above a third threshold for a period of time. The third threshold is greater than a first threshold used to determine a disconnection of the first capacitor; and responsive to determining that the measured voltage is above the third threshold, determine that the second capacitor is disconnected from the noise filter.

In some aspects, the techniques described herein relate to a system. The one or more controllers are further configured to: determine that the measured voltage is zero volts; and responsive to determining that the measured voltage is zero volts, determine that the first capacitor and the second capacitor are disconnected from the noise filter.

In some aspects, the techniques described herein relate to a system. The testing circuit further includes: an additional voltage divider including additional resistors; and an additional voltage detector configured to measure an additional voltage at the additional voltage divider. The one or more controllers are further configured to (iii) determine, from the output of the voltage detector and the additional output of the additional voltage detector, whether one or more of the first capacitor or the second capacitor are operating at a reduced capacity.

In some aspects, the techniques described herein relate to a system. Determining whether one or more of the first capacitor or the second capacitor are operating at the reduced capacity includes comparing the output with the additional output.

In some aspects, the techniques described herein relate to a system. The resistors have values of 500 KOhm, 500 KOhm, 500 KOhm and 5 KOhm respectively.

In some aspects, the techniques described herein relate to a system, further including: the battery configured to supply the DC power to the inverter; and the motor configured to receive the AC power from the inverter to drive the motor. The system is provided as a vehicle including the inverter, the battery, and the motor.

In some aspects, the techniques described herein relate to a method including performing, with one or more controllers, operations including: connecting a first capacitor of a noise filter and a second capacitor of the noise filter to a voltage divider; measuring, at a voltage detector connected to the voltage divider, a voltage at the first capacitor and the second capacitor; comparing the measured voltage against a threshold voltage; and responsive to the comparing, determining whether one or more of the first capacitor or the second capacitor is connected or disconnected from the noise filter.

In some aspects, the techniques described herein relate to a method. Determining whether one or more of the first capacitor or the second capacitor is connected or disconnected from the noise filter includes determining that that the first capacitor and the second capacitor are connected to the noise filter based on the measured voltage being greater than the threshold voltage.

In some aspects, the techniques described herein relate to a method. Determining whether one or more of the first capacitor or the second capacitor is connected or disconnected from the noise filter includes determining that that the first capacitor is disconnected from the noise filter based on the measured voltage being less than the threshold voltage.

In some aspects, the techniques described herein relate to a method. Determining whether one or more of the first capacitor or the second capacitor is connected or disconnected from the noise filter includes determining that that the first capacitor and the second capacitor are connected to the noise filter based on the measured voltage being zero volts.

In some aspects, the techniques described herein relate to a system including: a testing circuit configured to test one or more capacitors, the testing circuit including: a voltage divider; a voltage detector configured to measure a voltage at a first capacitor and a second capacitor, as a measured voltage; a switch configured to connect the first capacitor and the second capacitor to the voltage divider; and one or more controllers configured to (i) control an operation of the switch to connect the first capacitor and the second capacitor to the voltage divider, and to (ii) determine, from an output of the voltage detector, whether one or more of the first capacitor or the second capacitor are connected to a main circuit.

In some aspects, the techniques described herein relate to a system. The one or more controllers are further configured to: determine that the measured voltage is above a first threshold for a period of time; and responsive to determining that the measured voltage is above the first threshold for the period of time, determine that the first capacitor and the second capacitor are connected to the main circuit.

In some aspects, the techniques described herein relate to a system. The one or more controllers are further configured to: determine that the measured voltage is below a second threshold for a period of time; and responsive to determining that the measured voltage is below the second threshold for a period of time, determine that the first capacitor is disconnected from the main circuit.

In some aspects, the techniques described herein relate to a system. The one or more controllers are further configured to: determine that the measured voltage is above a third threshold for a period of time. The third threshold is greater than a first threshold used to determine a disconnection of the first capacitor; and responsive to determining that the measured voltage is above the third threshold, determine that the second capacitor is disconnected from the main circuit.

In some aspects, the techniques described herein relate to a system. The one or more controllers are further configured to: determine that the measured voltage is zero volts; and responsive to determining that the measured voltage is zero volts, determine that the first capacitor and the second capacitor are disconnected from the main circuit.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a combined inverter and converter, according to one or more embodiments.
FIG. 2 depicts an electrical power schematic of a three phase inverter module in a connected system, according to one or more embodiments.
FIG. 3 depicts an implementation of a computer system that may execute techniques presented herein, according to one or more embodiments.
FIG. 4 depicts an exemplary electrical schematic for an inverter, according to one or more embodiments.
FIG. 5 depicts an exemplary electrical schematic for a testing circuit for one or more capacitors, according to one or more embodiments.
FIG. 6 depicts an exemplary method for testing one or more capacitors, according to one or more embodiments.
FIGs. 7-10 depict exemplary plots for various signals in a testing circuit for testing one or more capacitors, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section.

Various embodiments of the present disclosure relate generally to testing one or more capacitors, and more particularly, but without limitation, to systems and methods for testing capacitors used in high voltage circuits such as inverters for use in electric vehicles. Some testing systems lack an ability to test a capacitor within an inverter circuit after the inverter circuit has been deployed in a vehicle.

By contrast, one or more embodiments may be applied to capacitors that are installed in a circuit, such as an inverter (a "main circuit"), for example. A testing circuit may determine whether one or more capacitors have become disconnected from the main circuit or are otherwise faulty, by measuring one or more voltages at the capacitors over time.

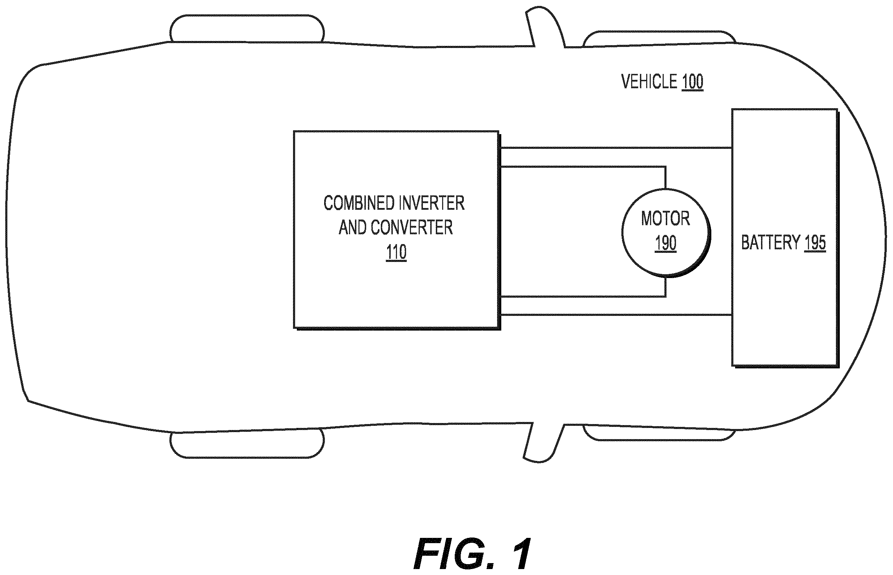

While the examples discussed herein describe testing one or more capacitors in circuits such as inverters, as discussed with respect to FIGS. 1-4, the disclosure is not limited thereto. Rather, one or more embodiments may be used to test a capacitor installed in any circuit.

FIG. 1 depicts an exemplary system infrastructure for a vehicle including a combined inverter and converter, according to one or more embodiments. Alternatively, the inverter may be an inverter without a converter. In the context of this disclosure, the inverter without a converter, or the combined inverter and converter, may be referred to as an inverter. As shown in FIG. 1, electric vehicle 100 may include an inverter 110, a motor 190, and a battery 195. The inverter 110 may include components to receive electrical power from an external source and output electrical power to charge the battery 195 of electric vehicle 100. The inverter 110 may convert DC power from the battery 195 in electric vehicle 100 to AC power, to drive (e.g. rotate) the motor 190 of the electric vehicle 100, for example, but the embodiments are not limited thereto. The inverter 110 may be bidirectional, and may convert DC power to AC power, or convert AC power to DC power, such as during regenerative braking, for example. The inverter 110 may be a three-phase inverter, a single-phase inverter, or a multi-phase inverter.

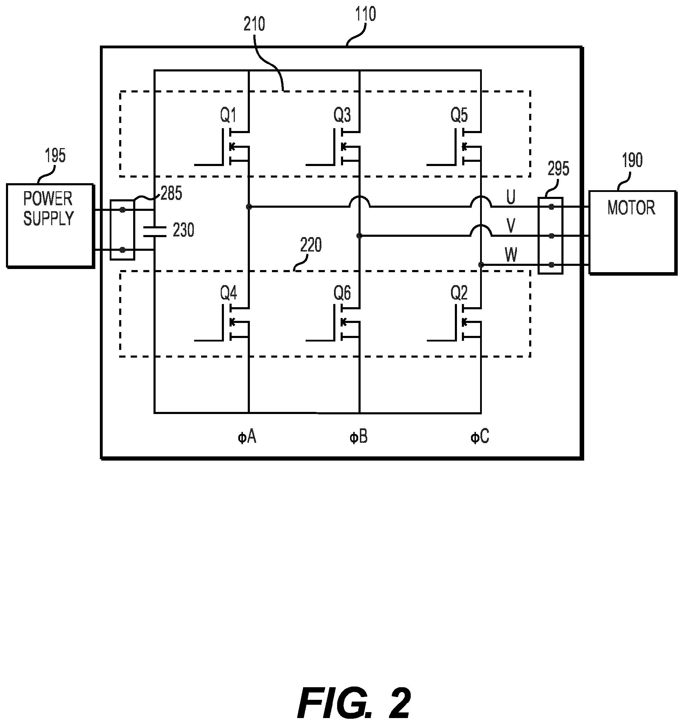

FIG. 2 depicts an electrical power schematic of a three phase inverter module, according to one or more embodiments. As shown in FIGS. 1 and 2, the inverter 110 may be connected to the battery 195 and the motor 190. Battery 195 may be any power supply, and motor 190 may be any load. The inverter 110 may include first three-phase switch group 210, and second three-phase switch group 220. A first phase U may correlate with ΦA including switches Q1 and Q4, a second phase V may correlate with ΦB including switches Q3 and Q6, and a third phase W may correlate with ΦC including switches Q5 and Q2, as illustrated in FIG. 2. The first three-phase switch group 210 may include first phase switch Q1, second phase switch Q3, and third phase switch Q5. The second three-phase switch group 220 may include first phase switch Q4, second phase switch Q6, and third phase switch Q2. The switches Q1-Q6 may be metal-oxide-semiconductor field-effect transistors (MOSFET), for example, but are not limited thereto.

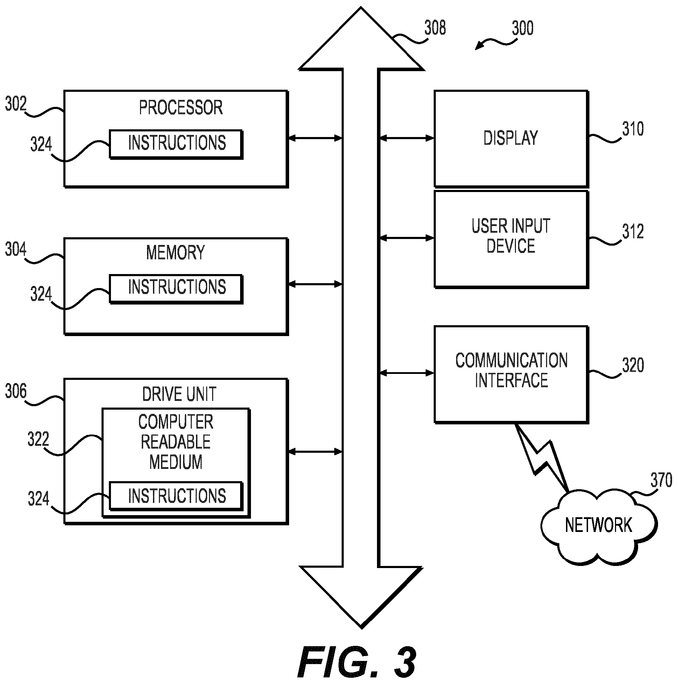

The first three-phase switch group 210 and second three-phase switch group 220 may be driven by a PWM signal generated by controller 300 (shown in FIG. 3) to convert DC power delivered via input terminal set 285 at capacitor 230 to three phase AC power at outputs U, V, and W via output terminal set 295 to the motor 190. Additionally, although FIGS. 1 and 2 illustrate a three-phase inverter, the disclosure is not limited thereto, and may include single phase or multi-phase inverters.

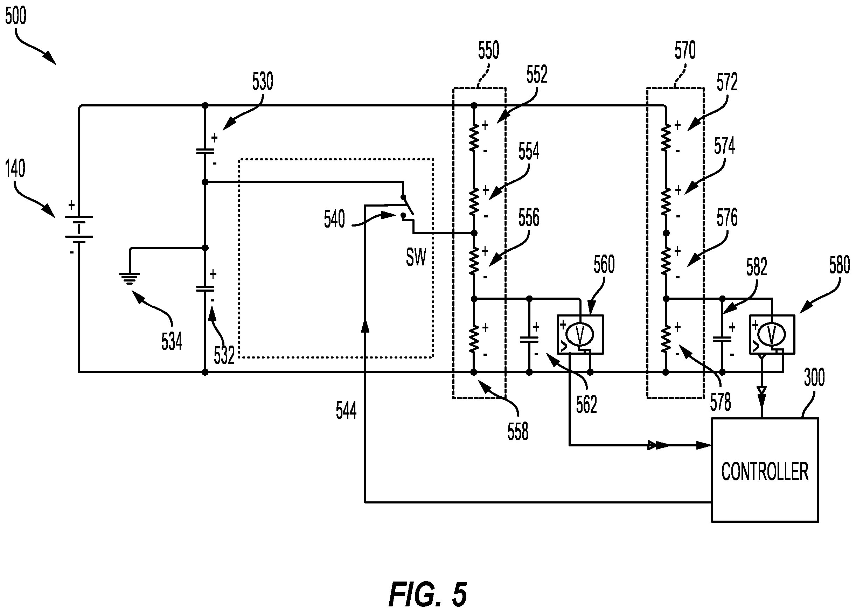

FIG. 3 depicts an implementation of a controller 300 that may execute techniques presented herein, according to one or more embodiments. For example, controller 300 may control the capacitor testing circuits discussed further with respect to FIG. 5. In some cases, controller 300 may operate as a detection circuit for a voltage relating to one or more capacitors. For example, a low voltage output from a voltage divider may be connected to an input of controller 300 to determine whether one or more capacitors are connected, as discussed further herein.

Any suitable system infrastructure may be put into place to allow control of the inverter. FIG. 3 and the following discussion provide a brief, general description of a suitable computing environment in which the present disclosure may be implemented. In one embodiment, any of the disclosed systems, methods, and/or graphical user interfaces may be executed by or implemented by a computing system consistent with or similar to that depicted in FIG. 3. Although not required, embodiments of the present disclosure are described in the context of computer-executable instructions, such as routines executed by a data processing device, e.g., a server computer, wireless device, and/or personal computer. Those skilled in the relevant art will appreciate that embodiments of the present disclosure may be practiced with other communications, data processing, or computer system configurations, including: Internet appliances, hand-held devices (including personal digital assistants ("PDAs")), wearable computers, all manner of cellular or mobile phones (including Voice over IP ("VoIP") phones), dumb terminals, media players, gaming devices, virtual reality devices, multi-processor systems, microprocessor-based or programmable consumer electronics, set-top boxes, network PCs, minicomputers, mainframe computers, and the like. Indeed, the terms "computer," "server," and the like, are generally used interchangeably herein, and refer to any of the above devices and systems, as well as any data processor.

Embodiments of the present disclosure may be embodied in a special purpose computer and/or data processor that is specifically programmed, configured, and/or constructed to perform one or more of the computer-executable instructions explained in detail herein. While embodiments of the present disclosure, such as certain functions, are described as being performed exclusively on a single device, the present disclosure may also be practiced in distributed environments where functions or modules are shared among disparate processing devices, which are linked through a communications network, such as a Local Area Network ("LAN"), Wide Area Network ("WAN"), and/or the Internet. Similarly, techniques presented herein as involving multiple devices may be implemented in a single device. In a distributed computing environment, program modules may be located in both local and/or remote memory storage devices.

Embodiments of the present disclosure may be stored and/or distributed on non-transitory computer-readable media, including magnetically or optically readable computer discs, hard-wired or preprogrammed chips (e.g., EEPROM semiconductor chips), nanotechnology memory, biological memory, or other data storage media. Alternatively, computer implemented instructions, data structures, screen displays, and other data under embodiments of the present disclosure may be distributed over the Internet and/or over other networks (including wireless networks), on a propagated signal on a propagation medium (e.g., an electromagnetic wave(s), a sound wave, etc.) over a period of time, and/or they may be provided on any analog or digital network (packet switched, circuit switched, or other scheme).

The controller 300 may include a set of instructions that may be executed to cause the controller 300 to perform any one or more of the methods or computer-based functions disclosed herein. The controller 300 may operate as a standalone device or may be connected, e.g., using a network, to other computer systems or peripheral devices.

In a networked deployment, the controller 300 may operate in the capacity of a server or as a client in a server-client user network environment, or as a peer computer system in a peer-to-peer (or distributed) network environment. The controller 300 may also be implemented as or incorporated into various devices, such as a personal computer (PC), a tablet PC, a set-top box (STB), a personal digital assistant (PDA), a mobile device, a palmtop computer, a laptop computer, a desktop computer, a communications device, a wireless telephone, a land-line telephone, a control system, a camera, a scanner, a facsimile machine, a printer, a pager, a personal trusted device, a web appliance, a network router, switch or bridge, or any other machine capable of executing a set of instructions (sequential or otherwise) that specify actions to be taken by that machine. **In** a particular implementation, the controller 300 may be implemented using electronic devices that provide voice, video, or data communication. Further, while the controller 300 is illustrated as a single system, the term "system" shall also be taken to include any collection of systems or sub-systems that individually or jointly execute a set, or multiple sets, of instructions to perform one or more computer functions.

As illustrated in FIG. 3, the controller 300 may include a processor 302, e.g., a central processing unit (CPU), a graphics processing unit (GPU), or both. The processor 302 may be a component in a variety of systems. For example, the processor 302 may be part of a standard computer. The processor 302 may be one or more general processors, digital signal processors, application specific integrated circuits, field programmable gate arrays, servers, networks, digital circuits, analog circuits, combinations thereof, or other now known or later developed devices for analyzing and processing data. The processor 302 may implement a software program, such as code generated manually (i.e., programmed).

The controller 300 may include a memory 304 that may communicate via a bus 308. The memory 304 may be a main memory, a static memory, or a dynamic memory. The memory 304 may include, but is not limited to computer readable storage media such as various types of volatile and non-volatile storage media, including but not limited to random access memory, read-only memory, programmable read-only memory, electrically programmable read-only memory, electrically erasable read-only memory, flash memory, magnetic tape or disk, optical media and the like. In one implementation, the memory 304 includes a cache or random-access memory for the processor 302. In alternative implementations, the memory 304 is separate from the processor 302, such as a cache memory of a processor, the system memory, or other memory. The memory 304 may be an external storage device or database for storing data. Examples include a hard drive, compact disc ("CD"), digital video disc ("DVD"), memory card, memory stick, floppy disc, universal serial bus ("USB") memory device, or any other device operative to store data. The memory 304 is operable to store instructions executable by the processor 302. The functions, acts or tasks illustrated in the figures or described herein may be performed by the processor 302 executing the instructions stored in the memory 304. The functions, acts or tasks are independent of the particular type of instructions set, storage media, processor or processing strategy and may be performed by software, hardware, integrated circuits, firm-ware, micro-code and the like, operating alone or in combination. Likewise, processing strategies may include multiprocessing, multitasking, parallel processing and the like.

As depicted, the controller 300 may further include a display 310, such as a liquid crystal display (LCD), an organic light emitting diode (OLED), a flat panel display, a solid-state display, a cathode ray tube (CRT), a projector, a printer or other now known or later developed display device for outputting determined information. The display 310 may act as an interface for the user to see the functioning of the processor 302, or specifically as an interface with the software stored in the memory 304 or in the drive unit 306.

Additionally or alternatively, the controller 300 may include an input device 312 configured to allow a user to interact with any of the components of controller 300. The input device 312 may be a number pad, a keyboard, or a cursor control device, such as a mouse, or a joystick, touch screen display, remote control, or any other device operative to interact with the controller 300.

The controller 300 may also or alternatively include drive unit 306 implemented as a disk or optical drive. The drive unit 306 may include a computer-readable medium 322 in which one or more sets of instructions 324, e.g. software, may be embedded. Further, the instructions 324 may embody one or more of the methods or logic as described herein. The instructions 324 may reside completely or partially within the memory 304 and/or within the processor 302 during execution by the controller 300. The memory 304 and the processor 302 also may include computer-readable media as discussed above.

In some systems, a computer-readable medium 322 includes instructions 324 or receives and executes instructions 324 responsive to a propagated signal so that a device connected to a network 370 may communicate voice, video, audio, images, or any other data over the network 370. Further, the instructions 324 may be transmitted or received over the network 370 via a communication port or interface 320, and/or using a bus 308. The communication port or interface 320 may be a part of the processor 302 or may be a separate component. The communication port or interface 320 may be created in software or may be a physical connection in hardware. The communication port or interface 320 may be configured to connect with a network 370, external media, the display 310, or any other components in controller 300, or combinations thereof. The connection with the network 370 may be a physical connection, such as a wired Ethernet connection or may be established wirelessly as discussed below. Likewise, the additional connections with other components of the controller 300 may be physical connections or may be established wirelessly. The network 370 may alternatively be directly connected to a bus 308.

While the computer-readable medium 322 is shown to be a single medium, the term "computer-readable medium" may include a single medium or multiple media, such as a centralized or distributed database, and/or associated caches and servers that store one or more sets of instructions. The term "computer-readable medium" may also include any medium that is capable of storing, encoding, or carrying a set of instructions for execution by a processor or that cause a computer system to perform any one or more of the methods or operations disclosed herein. The computer-readable medium 322 may be non-transitory, and may be tangible.

The computer-readable medium 322 may include a solid-state memory such as a memory card or other package that houses one or more non-volatile read-only memories. The computer-readable medium 322 may be a random-access memory or other volatile re-writable memory. Additionally or alternatively, the computer-readable medium 322 may include a magneto-optical or optical medium, such as a disk or tapes or other storage device to capture carrier wave signals such as a signal communicated over a transmission medium. A digital file attachment to an e-mail or other self-contained information archive or set of archives may be considered a distribution medium that is a tangible storage medium. Accordingly, the disclosure is considered to include any one or more of a computer-readable medium or a distribution medium and other equivalents and successor media, in which data or instructions may be stored.

In an alternative implementation, dedicated hardware implementations, such as application specific integrated circuits, programmable logic arrays and other hardware devices, may be constructed to implement one or more of the methods described herein. Applications that may include the apparatus and systems of various implementations may broadly include a variety of electronic and computer systems. One or more implementations described herein may implement functions using two or more specific interconnected hardware modules or devices with related control and data signals that may be communicated between and through the modules, or as portions of an application-specific integrated circuit. Accordingly, the present system encompasses software, firmware, and hardware implementations.

The controller 300 may be connected to a network 370. The network 370 may define one or more networks including wired or wireless networks. The wireless network may be a cellular telephone network, an 802.11, 802.16, 802.20, or WiMAX network. Further, such networks may include a public network, such as the Internet, a private network, such as an intranet, or combinations thereof, and may utilize a variety of networking protocols now available or later developed including, but not limited to TCP/IP based networking protocols. The network 370 may include wide area networks (WAN), such as the Internet, local area networks (LAN), campus area networks, metropolitan area networks, a direct connection such as through a Universal Serial Bus (USB) port, or any other networks that may allow for data communication. The network 370 may be configured to couple one computing device to another computing device to enable communication of data between the devices. The network 370 may generally be enabled to employ any form of machine-readable media for communicating information from one device to another. The network 370 may include communication methods by which information may travel between computing devices. The network 370 may be divided into sub-networks. The sub-networks may allow access to all of the other components connected thereto or the sub-networks may restrict access between the components. The network 370 may be regarded as a public or private network connection and may include, for example, a virtual private network or an encryption or other security mechanism employed over the public Internet, or the like.

In accordance with various implementations of the present disclosure, the methods described herein may be implemented by software programs executable by a computer system. Further, in an exemplary, non-limited implementation, implementations may include distributed processing, component/object distributed processing, and parallel processing. Alternatively, virtual computer system processing may be constructed to implement one or more of the methods or functionality as described herein.

Although the present specification describes components and functions that may be implemented in particular implementations with reference to particular standards and protocols, the disclosure is not limited to such standards and protocols. For example, standards for Internet and other packet switched network transmission (e.g., TCP/IP, UDP/IP, HTML, and HTTP) represent examples of the state of the art. Such standards are periodically superseded by faster or more efficient equivalents having essentially the same functions. Accordingly, replacement standards and protocols having the same or similar functions as those disclosed herein are considered equivalents thereof.

It will be understood that the steps of methods discussed are performed in one embodiment by an appropriate processor (or processors) of a processing (i.e., computer) system executing instructions (computer-readable code) stored in storage. It will also be understood that the disclosure is not limited to any particular implementation or programming technique and that the disclosure may be implemented using any appropriate techniques for implementing the functionality described herein. The disclosure is not limited to any particular programming language or operating system.

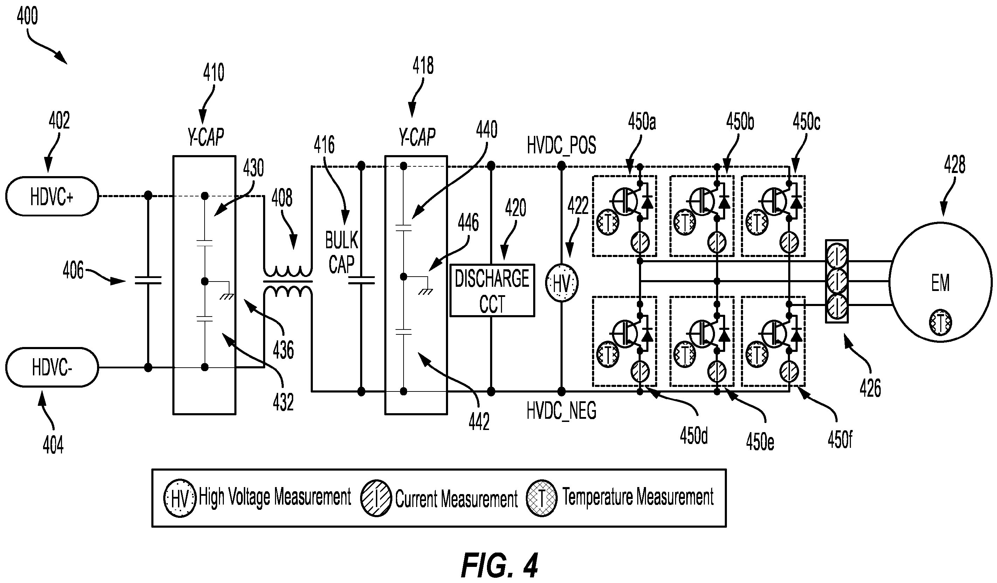

FIG. 4 depicts an exemplary electrical schematic for an inverter 400, according to one or more embodiments. Inverter 400 is a multi-phase inverter configured to receive direct current (DC) power, convert the DC power into multi-phase alternating current (AC) power using one or more phase switches, and provide the AC power to one or more motor windings of an electric motor. As discussed further herein, inverter 400 may include one or more capacitors that may be tested using the techniques discussed for example with respect to FIG. 5.

Inverter 400 includes positive DC voltage source 402, negative DC voltage source 404, bulk capacitor 406, noise filter (Y-cap) 410, inductor 408, bulk capacitor 416, noise filter (Y-cap) 418, discharge circuit 420, voltage measurement circuit 422, phase switch groups 450a-f, current measurement device 426, and electric motor 428. In the example depicted, inverter 400 receives power via positive DC voltage source 402 and negative DC voltage source 404 (e.g., via battery 140), reduces ripples and noise in the power via one or more of bulk capacitor 406, noise filter 410, inductor 408, bulk capacitor 416, or noise filter 418, converts the power to AC power via phase switch groups 450a-f, and provides the converted power to one or more windings of electric motor 428.

Noise may be introduced into the system and carried on positive DC voltage source 402 and/or negative DC voltage source 404. Noise filter 410 and noise filter 418 may be used to remove such noise. Noise filter 410 and noise filter 418 may each include two capacitors connected in series that filter noise on positive DC voltage source 402 and/or on negative DC voltage source 404. As depicted, noise filter 410 includes capacitor 430 and capacitor 432. Capacitor 430 is connected to positive DC voltage source 402, ground 436, and capacitor 432. Noise filter 418 includes capacitor 440 and capacitor 442. Capacitor 440 is connected to positive DC voltage source 402, to ground 446, and to capacitor 442.

Capacitor 430, capacitor 432, capacitor 440, and capacitor 442 may filter high frequency noise that may have coupled with the high voltage on positive DC voltage source 402 and/or the low voltage on negative DC voltage source 404, thereby reducing EMI/RFI noise and the related side effects. In some cases, capacitor 430, capacitor 432, capacitor 440, and capacitor 442 may be safety certified capacitors. Such capacitors are useful in the case that high voltages are used in the circuit, for instance, as may be the case with battery charging circuits.

Reliability of components within inverter 400 may be a concern, especially in rugged environments such as in electric vehicles. For example, one or more of capacitor 430, capacitor 432, capacitor 440, or capacitor 442 may become disconnected from inverter 400 (e.g. one or more of positive DC voltage source 402, negative DC voltage source 404, or ground 436) due to impact or vibration. Such a disconnection may result in inverter 400 not operating as designed.

Testing for failed or disconnected capacitors may be performed at the factory, e.g., before an inverter circuit is placed in a vehicle or before the vehicle is shipped. But such testing may not account for failures that occur in the field.

By contrast, one or more embodiments may test capacitors in inverter circuits after installation into electric vehicles, automatically, without user intervention. In some cases, capacitor testing may occur during or after purposeful impact or vibration testing. For example, impact and vibration testing may be performed with systems that include circuits such as inverter 400, as such systems may be designed to have a high tolerance for the effects of impact and vibration. Accordingly, one or more embodiments may test one or more of capacitor 430, capacitor 432, capacitor 440, or capacitor 442.

Inverter 400 may also include one or more bulk capacitors 406 and 416. A bulk capacitor may prevent an output voltage from dropping too low during periods where current may not be available. In some cases, one or more embodiments may be used to test whether bulk capacitor 406 and bulk capacitor 416 are connected to inverter 400.

Discharge circuit 420 may be used to discharge unused power or to discharge power in an event of a fault. Voltage measurement circuit 422 may be used to detect high voltages on inverter 400. Action may be taken, for instance via controller 300, to disable the circuit if a high voltage is detected.

Phase switch group 450a-f perform the DC to AC conversion. As depicted, each phase switch group 450a-f includes a phase switch (e.g., a transistor), a current sensor, and a temperature sensor. The current sensors may measure currents flowing through each respective phase switch. The temperature sensors may measure temperatures at one or more positions within the respective phase switch. The current and temperature measurements may be provided to controller 300. Action may be taken by via controller 300, should the measurements be out of range.

Current measurement device 426 may be used to measure currents flowing to the windings of electric motor 428. The current measurements may be provided to controller 300, which in turn may adjust the operation of electric motor 428.

FIG. 5 depicts an exemplary electrical schematic for a testing circuit 500 for one or more capacitors, according to one or more embodiments. In the example depicted, switch 540 is opened and/or closed and one or more voltages detected by voltage detectors 560 and 580 are analyzed to determine whether capacitor 530 and/or capacitor 532 are disconnected or non-operational.

Testing circuit 500 includes battery 140, ground 534, capacitor 530, capacitor 532, switch 540, control signal 544, voltage divider 550, voltage detector 560, voltage divider 570, voltage detector 580, and controller 300. Capacitor 530 may correspond to capacitor 430 or capacitor 440 of inverter 400. Capacitor 532 may correspond to capacitor 432 or capacitor 442 of inverter 400.

Controller 300 may control the operation of switch 540. As further explained below, testing circuit 500 may operate by controller 300 causing control signal 544 to open switch 540 or close switch 540 and to measure one or more voltages detected at voltage detectors 560 and/or 580 when switch 540 is closed. Switch 540 may be any type of switch. In an example, switch 540 may be a relay, due to the high voltages and currents being handled. In other cases, switch 540 may be may be a MOSFET switch.

Each voltage divider 550 and 570 may include multiple resistors. For instance, as depicted, voltage divider 550 includes resistors 552, 554, 556, and 558 and voltage divider 570 includes resistors 572, 574, 576, and 578. But any number of resistors are possible. Voltage divider 550 may include capacitor 562 and voltage divider 570 may include capacitor 582. Voltage dividers 550 and 570 are each connected to voltage detectors 560 and 580 respectively. Voltage divider 570 and voltage detector 580 may not always be used, and in some cases, may serve to provide redundancy in the case of a failure. However, in some cases, voltage dividers 550 and 570 operate together, for example, to detect a drift of capacitor 530 or capacitor 532.

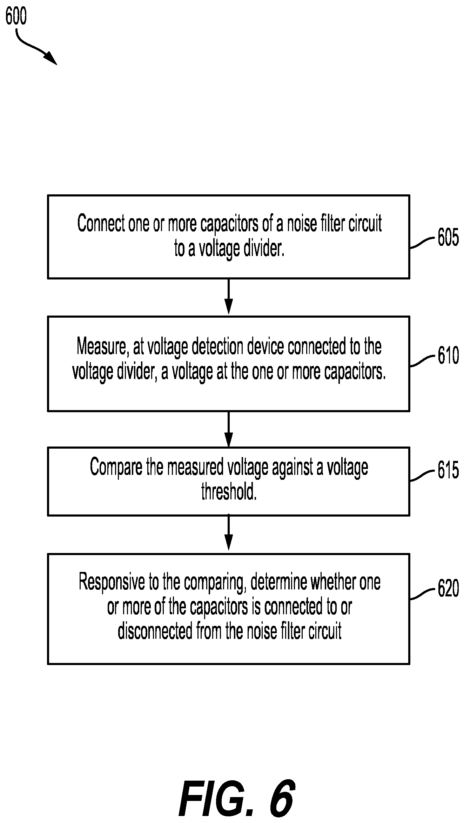

Signals received from the voltage detector 560 and voltage detector 580 may indicate whether capacitor 530 and/or capacitor 532 are connected to or disconnected from the circuit 500, as discussed further with respect to FIG. 6. Voltage detector 560 and voltage detector 580 each may output a respective signal indicative of a detected voltage to controller 300.

When switch 540 is open, the voltage detected at voltage detector 560 is a scaled voltage based on the DC positive source voltage, according to the particular resistor values of the resistors 556 and 558 of voltage divider 550. By contrast, when switch 540 is closed, the detected voltage at voltage detector 560 varies based on whether capacitor 530 and capacitor 532 are connected to the circuit and functioning properly, for example, as discussed with respect to FIGs. 6-10.

In an example, the values of resistors 552, 554, 556, and 558 may be 500 KOhm, 500 KOhm, 500 KOhm, and 5 KOhm respectively. The values of the resistors may be adjusted such that the output of the voltage divider is compatible with the voltage detection device, which may in some cases involve a controller. In some cases, additional resistors may be used if the power rating is such that the load should be shared across an additional number of resistors.

Voltage detector 560 may be implemented via a comparator and/or a controller. For instance, a comparator may receive the input to voltage detector 560 and compare the voltage. In other cases, controller 300 may include an input configured to perform the detection. In higher voltage applications, additional buffer circuitry may be used.

The output of voltage divider 570 is based on the value of resistor 578 as compared to the values of resistors 572, resistor 574, and resistor 576. In an example, the values of resistors 572, resistor 574, resistor 576, and resistor 578 may be 500 KOhm, 500 KOhm, 500 KOhm, and 5 KOhm respectively.

FIG. 6 depicts an exemplary method 600 for testing one or more capacitors, according to one or more embodiments. For illustrative purposes, method 600 is discussed with respect to testing circuit 500 controlled by controller 300. However, method 600 may be applied to other capacitor testing circuits and/or be implemented by different controllers. Further, while method 600 depicts various operations, not all the operations listed may be performed and/or some operations may be repeated as appropriate.

At block 605, method 600 may involve connecting one or more capacitors of a noise filter to a voltage divider. For instance, referring back to FIG. 5, controller 300 causes switch 540 to close, thereby connecting the capacitor 530 and capacitor 532 to the voltage divider 550.

At block 610, method 600 may involve measuring, at a voltage detector connected to the voltage divider, a voltage at one or more of the capacitors. Continuing the example, voltage detector 560 receives the voltage from the capacitors. The received voltage may be passed to controller 300.

The voltage output from voltage divider 550 is scaled according to the specific resistances used in voltage divider 550, for instance, resistors 552, 554, 556, and 558. In an aspect, measurement of the voltage may take place over a period, or a window, of time. In an example, a window of 200 milliseconds (ms) is used. Multiple samples may be obtained and the sampling frequency may be adjusted.

At block 615, method 600 may involve comparing the measured voltage against a threshold voltage. Controller 300 compares the measured voltage received at block 610 with one or more threshold voltages. As discussed herein, the measured voltage may determine whether each of capacitor 530 and capacitor 532 are working correctly and are connected to the circuit or are defective or disconnected. As discussed below, multiple different thresholds may be used.

At block 620, method 600 may involve responsive to the comparing, determining whether one or more of the capacitors is connected or disconnected from the noise filter. Different scenarios are possible, such as both capacitor 530 and capacitor 532 being connected, capacitor 530 being disconnected, capacitor 532 being disconnected, and both capacitor 530 and capacitor 532 being disconnected.

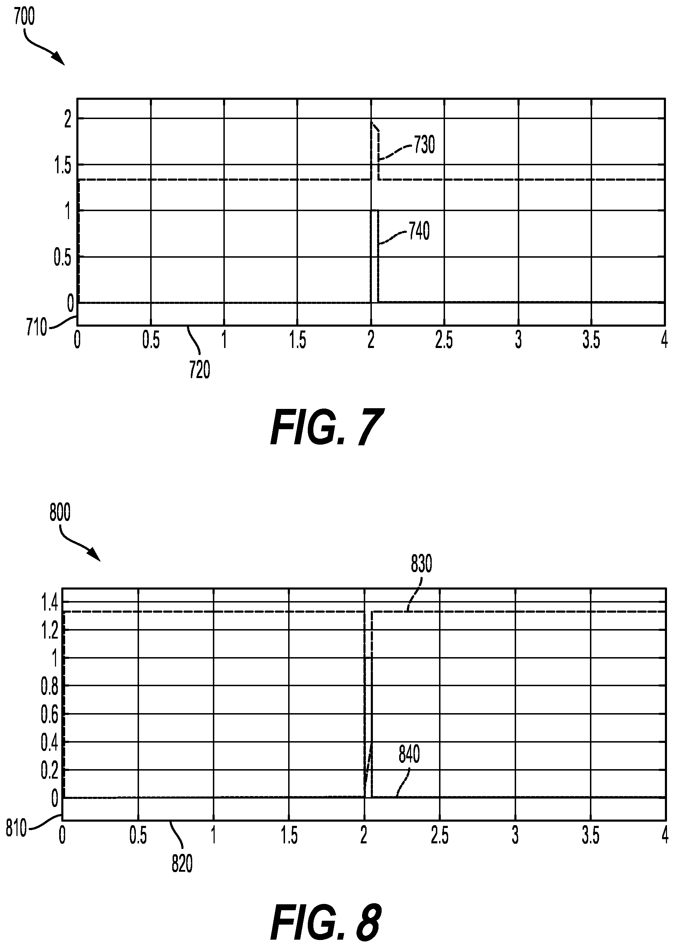

In one example, at block 620, method 600 may involve determining that both capacitor 530 and capacitor 532 are connected. For instance, if capacitor 530 and capacitor 532 are connected, a detected voltage may increase above a first threshold when switch 540 is closed. As illustrated further with respect to FIG. 7, a detected voltage being above a first threshold for the period of time may indicate that capacitor 530 and capacitor 532 are connected to the circuit.

In another example, at block 620, method 600 may involve determining that capacitor 530 is disconnected. For instance, if capacitor 530 is disconnected, the detected voltage may decrease below, or less than, a second threshold. As illustrated further with respect to FIG. 8, a detected voltage being below the second threshold for a period of time may indicate that capacitor 530 is disconnected from circuit 500.

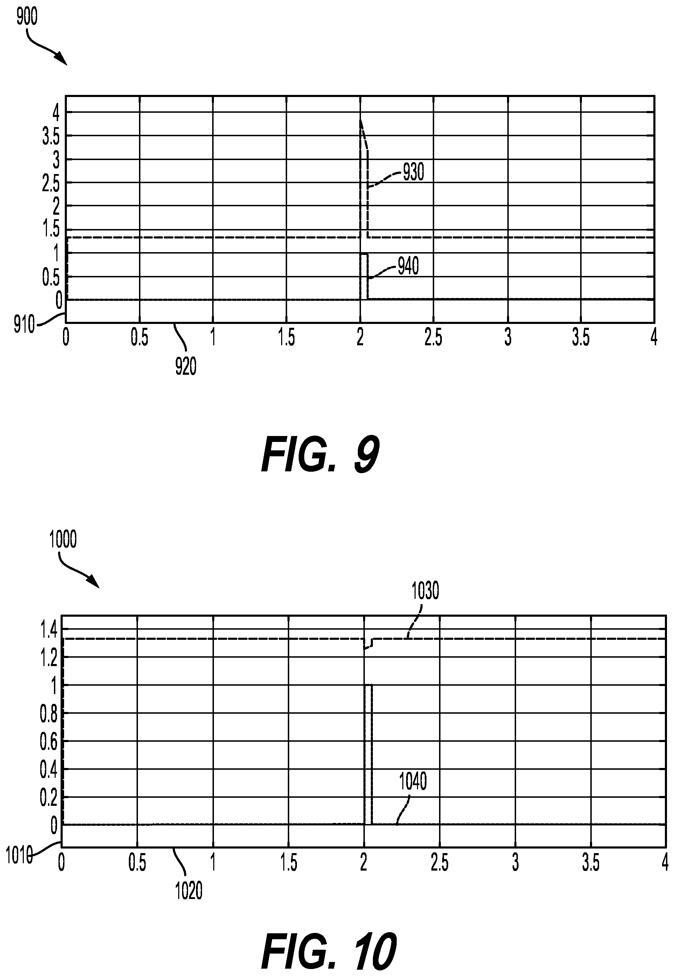

In yet another example, at block 620, method 600 may involve determining that capacitor 532 is disconnected. For instance, if capacitor 532 is disconnected, a detected voltage may increase when switch 540 is closed. As illustrated further with respect to FIG. 9, a detected voltage being above a third threshold for the period of time may indicate that capacitor 532 is disconnected from circuit 500. The third threshold may be greater than the first threshold discussed above.

In yet another example, method 600 may involve determining that neither capacitor 530 nor capacitor 532 is connected. For example, if the detected voltage is zero volts, then neither capacitor 530 and 532 is connected.

In yet another example, method 600 may involve determining that one or more of capacitor 530 or capacitor 532 are connected but are operating on a reduced capacity, or with a "drift." One or both of capacitor 530 and capacitor 532 may have "drift." In this case, the voltage divider 570 and voltage detector 580 are used to determine an additional voltage. The additional voltage is then compared with the voltage measured via voltage divider 550 and voltage detector 560.

Continuing the example, if one or more of the first capacitor or the second capacitor are operating at a reduced capacity, then the voltage measured at voltage detector 560 will be different than a voltage measured at voltage detector 580.

FIG. 7 depicts exemplary plots 700 for various signals in a testing circuit for testing one or more capacitors, according to one or more embodiments. In the example depicted, capacitor 530 and capacitor 532 are operational and are connected.

Plots 700 include plots 730 and 740, each of which are measurements of voltage 710 against time 720. The signal represented by plot 730 represents a measured output of the voltage detector and the signal represented by plot 740 represents a control signal of the switch 540.

In the example depicted, a zero voltage on plot 740 indicates that switch 540 is open, whereas a non-zero (e.g., 1 Volt) voltage on plot 740 indicates that switch 540 is closed. Plot 740 indicates that the control signal for switch 540 is initially open and remains so until approximately 2 seconds, at which time, switch 540 is closed.

The signal represented by plot 730 represents a detected voltage of the voltage detector initially rising from 0 Volts to approximately 1.3 Volts. This value may be determined from the positive DC voltage, which in this example is 400 Volts, across the voltage divider 550. For instance, given values of 500 K Ohm for each of resistors 552, 554, 556, and a value of 5 K Ohm for resistor 558, the measured voltage with switch 540 open is approximately 1.3 Volts.

Then, when switch 540 is closed at approximately 2 seconds in this example, the voltage rises further to a peak of approximately 2 Volts. This value may be determined by considering that when both capacitor 530 and capacitor 532 are connected, operational, and of equal value, the positive DC voltage of 400 Volts is divided evenly across capacitor 530 and capacitor 532. Accordingly, a value of 200 Volts is provided to voltage divider 550, and is split according to the resistance values of resistors 556 and 558, which are 500 KOhm and 5 KOhm, respectively.

As depicted, switch 540 remains open for a time period of approximately 200 ms. During the time period, the signal represented by plot 730 decreases, as the capacitor 530 and capacitor 532 discharge through the resistors of the voltage divider.

To detect this rise of the signal represented by plot 730, a threshold may be used. Above this threshold, capacitor 530 and capacitor 532 are determined to be operational. The precise threshold may vary based on configuration of the circuit 500, but in the example depicted, a threshold may be approximately 1.6-1.7 Volts.

FIG. 8 depicts exemplary plots 800 for various signals in a testing circuit for one or more capacitors, according to one or more embodiments. In the example depicted, capacitor 530 is not operational or is disconnected.

Plots 800 include plots 830 and 840, each of which are measurements of voltage 810 against time 820. The signal represented by plot 830 represents a measured output of the voltage detector and the signal represented by plot 840 represents a control signal of the switch 540.

In the example depicted, a zero voltage on plot 840 indicates that switch 540 is open, whereas a non-zero (e.g., 1 Volt) voltage on plot 840 indicates that switch 540 is closed. Plot 840 indicates that the control signal for switch 540 is initially open and remains so until approximately 2 seconds, at which time, switch 540 is closed.

The signal represented by plot 830 represents a detected voltage of the voltage detector initially rising from 0 Volts to approximately 1.3 Volts. Then, when switch 540 is closed at approximately 2 seconds in this example, the voltage decreases to approximately 0 Volts.

If capacitor 530 is open, then the value passed to the voltage divider 550 is zero volts. Accordingly, the resistors 556 and 558 are shorted. As depicted, switch 540 remains open for a time period of approximately 200 ms. During the time period, the signal represented by plot 830 increases, as capacitor 532 is charged via current flowing from the resistors of the voltage divider. If the time period is long enough, then capacitor 532 will be fully charged and the voltage will rise to approximately 1.3 Volts.

To detect this decrease of the signal represented by plot 830, a threshold may be used. Below this threshold, capacitor 530 is determined to be non-operational or disconnected. The precise threshold may vary based on configuration of the circuit 500, but in the example depicted, a threshold may be approximately 0.1-0.2 Volts.

FIG. 9 depicts exemplary plots 900 for various signals in a testing circuit for one or more capacitors, according to one or more embodiments. In the example depicted, capacitor 532 is not operational or is disconnected.

Plots 900 include plots 930 and 940, each of which are measurements of voltage 910 against time 920. The signal represented by plot 930 represents a measured output of the voltage detector and the signal represented by plot 940 represents a control signal of the switch 540.

In the example depicted, a zero voltage on plot 940 indicates that switch 540 is open, whereas a non-zero (e.g., 1 Volt) voltage on plot 940 indicates that switch 540 is closed. Plot 940 indicates that the control signal for switch 540 is initially open and remains so until approximately 2 seconds, at which time, switch 540 is closed.

The signal represented by plot 930 represents a detected voltage of the voltage detector initially rising from 0 Volts to approximately 1.3 Volts. Then, when switch 540 is closed at approximately 2 seconds in this example, the voltage rises further to a peak of approximately 4 Volts.

This 4 Volt value may be determined by considering that when both capacitors 530 and 532 are connected and operational, the positive DC voltage of 400 Volts is provided to voltage divider 550, and is split according to the resistance values of resistors 556 and 558, which are 500 KOhm and 5 KOhm respectively.

As depicted, switch 540 remains open for a time period of approximately 200 ms. During the time period, the signal represented by plot 730 decreases, as the capacitor 530 discharges through the resistors of the voltage divider.

To detect this rise of the signal represented by plot 730, a threshold may be used. Above this threshold, capacitor 530 and capacitor 532 are determined to be operational. The precise threshold may vary based on configuration of the circuit 500, but in the example depicted, a threshold may be approximately 3.4-3.6 Volts.

FIG. 10 depicts exemplary plots 1000 for various signals in a testing circuit for one or more capacitors, according to one or more embodiments, each of which are measurements of voltage 1010 against time 1020. In the example depicted, capacitor 530 is partially operational with a drift of 50%, which represents a 50% availability of the specified capacitance.

Plots 1000 include plots 1030 and 1040. The signal represented by plot 1030 represents a measured output of the voltage detector and the signal represented by plot 1040 represents a control signal of the switch 540.

In the example depicted, a zero voltage on plot 1040 indicates that switch 540 is open, whereas a non-zero (e.g., 1 Volt) voltage on plot 1040 indicates that switch 540 is closed. Plot 1040 indicates that the control signal for switch 540 is initially open and remains so until approximately 2 seconds, at which time, switch 540 is closed.

The signal represented by plot 1030 represents a detected voltage of the voltage detector initially rising from 0 Volts to approximately 1.3 Volts. Then, when switch 540 is closed at approximately 2 seconds in this example, the voltage dips to approximately 1.25 Volts. In some cases, a determination of drift may be made when the voltage drops below a fourth threshold. This fourth threshold may be higher than the second threshold discussed above.

In this example, voltage divider 550, voltage divider 570, voltage detector 560, and voltage detector 580 are used. For example, when a detected voltage from voltage detector 560 differs from a detected voltage from voltage detector 580 by more than a threshold, then a determination may be made that drift exists on one or more of capacitor 530 or capacitor 532.

Capacitor 530 having a 50% drift means that a voltage drop across capacitor 530 is one-third of the total voltage drop, whereas the voltage drop across capacitor 532 is two-thirds of the total voltage drop. By contrast, with no drift, the voltage drop across the capacitors is approximately equal.

One or more embodiments may be applied to capacitors that are installed in a circuit, such as an inverter (a "main circuit"), for example. One or more embodiments may provide a testing circuit that may allow the main circuit to operate independently from the testing circuit. One or more embodiments may determine whether one or more capacitors have become disconnected from the main circuit or is otherwise faulty.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A system comprising:
an inverter to convert DC power from a battery to AC power to drive a motor,
wherein the inverter includes:
a noise filter including a first capacitor connected in series with a second capacitor; and
a testing circuit configured to test one or more of the first capacitor or the second capacitor, the testing circuit including:
a voltage divider comprising a plurality of resistors;
a voltage detector configured to measure a voltage at the voltage divider;
a switch configured to connect the noise filter to the voltage divider; and
one or more controllers configured to (i) control an operation of the switch to connect the noise filter to the voltage divider, and to (ii) determine, from an output of the voltage detector, whether one or more of the first capacitor or the second capacitor are connected to the noise filter.

2. The system of claim 1, wherein the voltage divider and the noise filter are connected to a positive DC voltage source and to a negative DC voltage source.

3. The system of any one of claims 1 to 2, wherein the plurality of resistors comprise a first resistor, a second resistor, a third resistor, and a fourth resistor, wherein the first resistor is connected to a positive DC voltage source and the second resistor, wherein the second resistor is connected to the third resistor, and wherein the voltage detector is connected to the third resistor and the fourth resistor.

4. The system of any one of claims 1 to 3, wherein the one or more controllers are further configured to:
determine that the measured voltage is above a first threshold for a period of time; and
responsive to determining that the measured voltage is above the first threshold for the period of time, determine that the first capacitor and the
second capacitor are connected to the noise filter;
and/or, wherein the one or more controllers are further configured to:
determine that the measured voltage is below a second threshold for a period of time; and
responsive to determining that the measured voltage is below the second threshold for a period of time, determine that the first capacitor is disconnected from the noise filter.

5. The system of any one of claims 1 to 4, wherein the one or more controllers are further configured to:
determine that the measured voltage is above a third threshold for a period of time, wherein the third threshold is greater than a first threshold used to determine a disconnection of the first capacitor; and
responsive to determining that the measured voltage is above the third threshold, determine that the second capacitor is disconnected from the noise filter;
and/or, wherein the one or more controllers are further configured to:
determine that the measured voltage is zero volts; and
responsive to determining that the measured voltage is zero volts, determine that the first capacitor and the second capacitor are disconnected from the noise filter.

6. The system of any one of claims 1 to 5, wherein the testing circuit further includes:
an additional voltage divider comprising a plurality of additional resistors; and
an additional voltage detector configured to measure an additional voltage at the additional voltage divider, wherein the one or more controllers are further configured to (iii) determine, from the output of the voltage detector and the additional output of the additional voltage detector, whether one or more of the first capacitor or the second capacitor are operating at a reduced capacity;
and wherein, preferably, determining whether one or more of the first capacitor or the second capacitor are operating at the reduced capacity comprises comparing the output with the additional output.

7. The system of any one of claims 1 to 6, wherein the plurality of resistors have values of 500 KOhm, 500 KOhm, 500 KOhm and 5 KOhm respectively.

8. The system of any one of claims 1 to 7, further including:
the battery configured to supply the DC power to the inverter; and
the motor configured to receive the AC power from the inverter to drive the motor,
wherein the system is provided as a vehicle including the inverter, the battery, and the motor.

9. A method comprising performing, with one or more controllers, operations including:
connecting a first capacitor of a noise filter and a second capacitor of the noise filter to a voltage divider;
measuring, at a voltage detector connected to the voltage divider, a voltage at the first capacitor and the second capacitor;
comparing the measured voltage against a threshold voltage; and
responsive to the comparing, determining whether one or more of the first capacitor or the second capacitor is connected or disconnected from the noise filter.

10. The method of claim 9, wherein determining whether one or more of the first capacitor or the second capacitor is connected or disconnected from the noise filter comprises determining that that the first capacitor and the second capacitor are connected to the noise filter based on the measured voltage being greater than the threshold voltage;
and/or, wherein determining whether one or more of the first capacitor or the second capacitor is connected or disconnected from the noise filter comprises determining that that the first capacitor is disconnected from the noise filter based on the measured voltage being less than the threshold voltage.

11. The method of claim 9 or 10, wherein determining whether one or more of the first capacitor or the second capacitor is connected or disconnected from the noise filter comprises determining that that the first capacitor and the second capacitor are connected to the noise filter based on the measured voltage being zero volts.

12. A system comprising:
a testing circuit configured to test one or more capacitors, the testing circuit comprising:
a voltage divider;
a voltage detector configured to measure a voltage at a first capacitor and
a second capacitor, as a measured voltage;
a switch configured to connect the first capacitor and the second capacitor to the voltage divider; and
one or more controllers configured to (i) control an operation of the switch to connect the first capacitor and the second capacitor to the voltage divider,
and to (ii) determine, from an output of the voltage detector, whether one or more of the first capacitor or the second capacitor are connected to a main circuit.

13. The system of claim 12, wherein the one or more controllers are further configured to:
determine that the measured voltage is above a first threshold for a period of time; and
responsive to determining that the measured voltage is above the first threshold for the period of time, determine that the first capacitor and the second capacitor are connected to the main circuit.

14. The system of any one of claims 12 to 13, wherein the one or more controllers are further configured to:
determine that the measured voltage is below a second threshold for a period of time; and
responsive to determining that the measured voltage is below the second threshold for a period of time, determine that the first capacitor is disconnected from the main circuit.

15. The system of any one of claims 12 to 14, wherein the one or more controllers are further configured to:
determine that the measured voltage is above a third threshold for a period of time, wherein the third threshold is greater than a first threshold used to determine a disconnection of the first capacitor; and
responsive to determining that the measured voltage is above the third threshold, determine that the second capacitor is disconnected from the main circuit;
and/or, wherein the one or more controllers are further configured to:
determine that the measured voltage is zero volts; and
responsive to determining that the measured voltage is zero volts, determine that the first capacitor and the second capacitor are disconnected from the main circuit.
